Europäisches Patentamt

European Patent Office

Office européen des brevets

(11) Publication number: **0 096 896**
**B1**

# EUROPEAN PATENT SPECIFICATION

(45) Date of publication of patent specification: 30.12.86

(51) Int. Cl.⁴: **H 03 K 5/13,** G 11 C 7/00

(21) Application number: 83105868.0

(22) Date of filing: 15.06.83

(54) Signal transmitting circuit.

(30) Priority: 15.06.82 JP 102618/82

(43) Date of publication of application:
28.12.83 Bulletin 83/52

(45) Publication of the grant of the patent:
30.12.86 Bulletin 86/52

(84) Designated Contracting States:
DE FR GB

(56) References cited:
EP-A-0 050 037
US-A-3 155 959
US-A-3 641 370
US-A-4 122 361
US-A-4 272 834

IBM TECHNICAL DISCLOSURE BULLETIN, vol.
13, no. 2, July 1970 D.J. KOSTUCH "Time delay
for MOSFET integrated logic", pages 519, 520
Patent Abstracts of Japan vol. 1, no. 112, 28
September 1977 page 4175E77 & JP-A-52-
45247

(73) Proprietor: **NEC CORPORATION**
**33-1, Shiba 5-chome, Minato-ku**
**Tokyo 108 (JP)**

(72) Inventor: **Ozawa, Takashi**
**c/o NEC Corporation 33-1, Shiba 5-chome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

## Description

The present invention relates to a signal transmitting circuit comprising a first series connection of a first transistor and a first load element at a first junction, a second series connection of a second transistor and a second load element at a second junction, means for supplying a control electrode of said first transistor with an input signal, means for receiving a control signal having first and second logic levels, said input signal being provided during a first period when said control signal assumes said first logic level, a variable time constant circuit coupled between said first junction and a control electrode of said second transistor, control means responsive to said control signal for setting a delay time at the control electrode of said second transistor caused by said variable time constant circuit at one of a first delay time and a second delay time longer than said first delay time, and output means for deriving an output signal from said second junction.

A signal transmitting circuit of this kind is known from patent abstracts of Japan volume 1, no. 112, page 4175E77, Kokai number 52-45247. In this circuit the input signal serves simultaneously as the control signal which sets the delay time at the control electrode of the second transistor. This, however, means that the known circuit only works, when the input signal changes from a low level to a high level. Therefore this circuit has the disadvantage that it cannot be used for transmitting an input signal which assumes either of the binary logic levels.

On the other hand it is known from US—A— 36 41 370 to use a plurality of delay signal paths each of which is composed of a MOS-transistor and a capacitor. However, in this known clock signal generator the delay time of each delay signal paths is changed by adjusting the gate voltage of the MOS-transistor by means of a variable resistor. When this gate voltage is once set, the delay time is kept constant throughout the whole operation of the clock signal generator. Therefore, the effective period of the output signal is the same as the effective period of the input signal and therefore no extension of the effective period can be achieved by means of this circuit.

It is therefore the object of the invention to provide a signal transmitting circuit of the known kind the output signal of which can be generated during a longer period than the effective period of the input signal without materially delaying the appearance of the output signal so that a logic process on this extended output signal can be handled with ease.

This object according to the present invention is achieved for a signal transmitting circuit of the known kind by the features that said control means makes the delay time at the control electrode of said second transistor said first delay time when said control signal changes from said second level to said first level and said second delay time when said control signal changes from said first level to said second level irrespective of value of said input signal, and that the output signal is derived during a second period longer than said first period.

By means of these features a signal transmitting circuit is provided in which an input signal is applied in synchronism with a control signal and in which the output signal is derived after a first delay time from the application of the input signal and the generation of the output signal is terminated after a second, longer delay time from the determination of the application of the input signal. In other words, according to the invention, the output signal is produced as soon as the input signal is provided and the output signal is still maintained for the second longer delay time after the termination of the input signal. Thus, the output signal can be generated during a longer period than the effective period of the input signal irrespective of the value of said input signal and without materially delaying the appearance of the output signal. In the signal transmitting circuit according to the present invention the delay response characteristic can be controlled by an internal control signal and can be varied according to the necessities of the logic circuits of the next stage.

The above-mentioned and other objects, features and advantages of the present invention will become more apparent by reference to the following description of preferred embodiments of the invention taken in conjunction with the accompanying drawings, wherein,

Fig. 1 is a schematic view showing a part of a write circuit of a static memory in the prior art,

Fig. 2 is a diagram showing a timing selection between an input and an output in a DIN circuit,

Fig. 3 shows one example of a write pattern which indicates an influence in the case where a DIN input propagation time $T_0$ is long,

Fig. 4 shows another example of a write pattern which indicates an influence in the case where a DIN input propagation time $T_0$ is short,

Fig. 5 is a circuit diagram showing one preferred embodiment of the present invention,

Fig. 6 is a time chart showing the relation between a write signal $\overline{WE}$ and a signal $\phi_1$ in Fig. 5,

Fig. 7 is a circuit diagram showing another preferred embodiment of the present invention, and

Fig. 8 is a timing chart showing the relation between a write signal $\overline{WE}$ and a signal $\phi_2$ in Fig. 7.

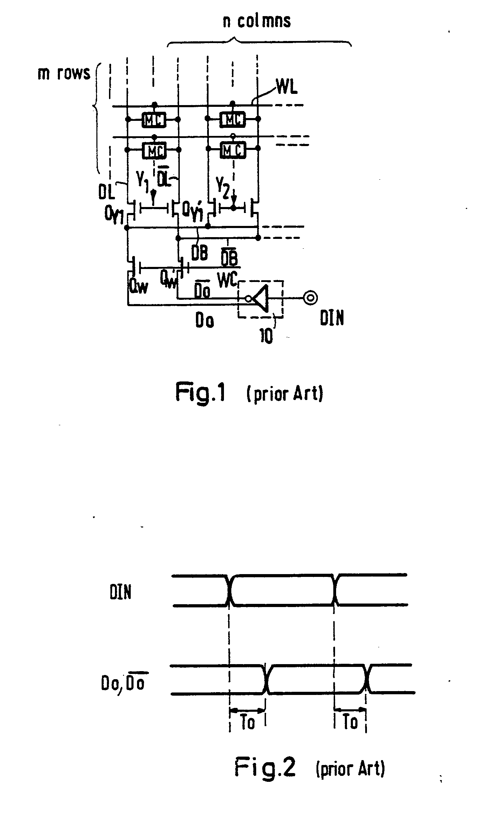

Now description will be made of an essential part of a static memory in the prior art, with reference to Fig. 1.

Memory cells MC of flip-flop type are disposed at cross-points between m rows of word lines WL and n columns of digit line pairs (DL, $\overline{DL}$). Each digit line pair (DL, $\overline{DL}$) is connected to a data bus pair (DB, $\overline{DB}$) through a column selection transistor pair ($Q_{Y1}$, $Q'_{Y1}$) which operates in response to a column selection signal $Y_1$ or the

like. To the pair of buses $(DB, \overline{DB})$ are applied true and complementary buffer outputs of a data circuit 10 which receives a data input DIN, through a pair of write gate transistors $Q_w$ and $Q_w'$, respectively. These write gate transistor $Q_w$ and $Q_w'$ are made conducting upon write operation by an internal write signal WC that is generated by the write signal WE. Upon write operation, the write switching MISFET's $Q_w$ and $Q_w'$ become conducting, and hence data corresponding to the DIN signal is written in the selected memory cell. On the other hand, upon read operation, since the write switching MISFET's $Q_w$ and $Q_w'$ do not become conducting, write to any memory cell is not effected.

In Fig. 2 is shown a relation between the signal DIN and the output signal of the circuit 10. Normally, the output of the DIN circuit 10 is drawn out as effective data having a time difference $T_0$ with respect to the input DIN to the same circuit. This time difference $T_0$ would cause inconvenience in the write operation of the memory either in the case where it is too long or in the case where it is too short.

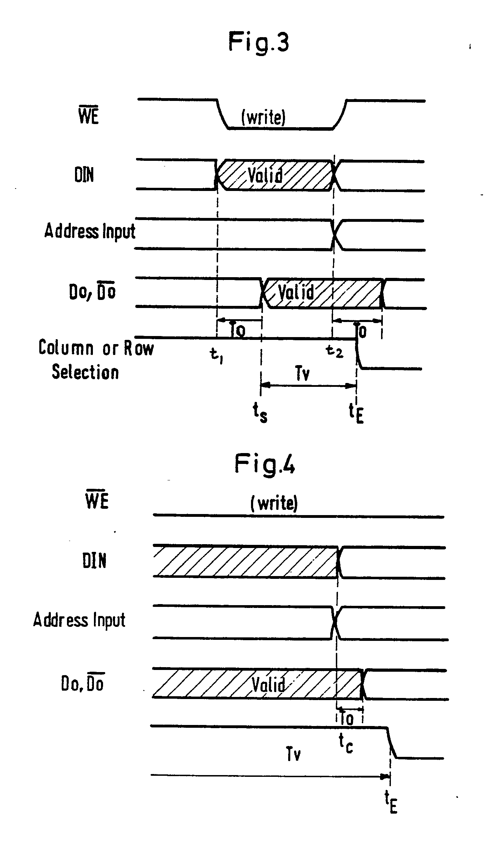

Fig. 3 shows the case where a write enable signal $\overline{WE}$ is applied in a pulse form at a time point $t_1$, and at the same time a write data signal DIN is made valid and address input signals are effective, and then the state transfers from a write state to a read state at a time point $t_2$. In the case where the $\overline{WE}$ signal is short as shown in Fig. 3 if the time difference $T_0$ is too long, then an effective write time $T_v$ to a selected memory cell that is dependent upon the effective output of the data circuit 10 becomes short, and in the worst case an inconvenience would occur that write operation is impossible. More particularly, since a time point $t_s$ when the output of the data circuit 10 becomes effective is delayed by a period $T_0$, the effective write period $T_v$ between this time point $t_s$ and a time point $t_E$ when the column or row selection is finished, would be shortened.

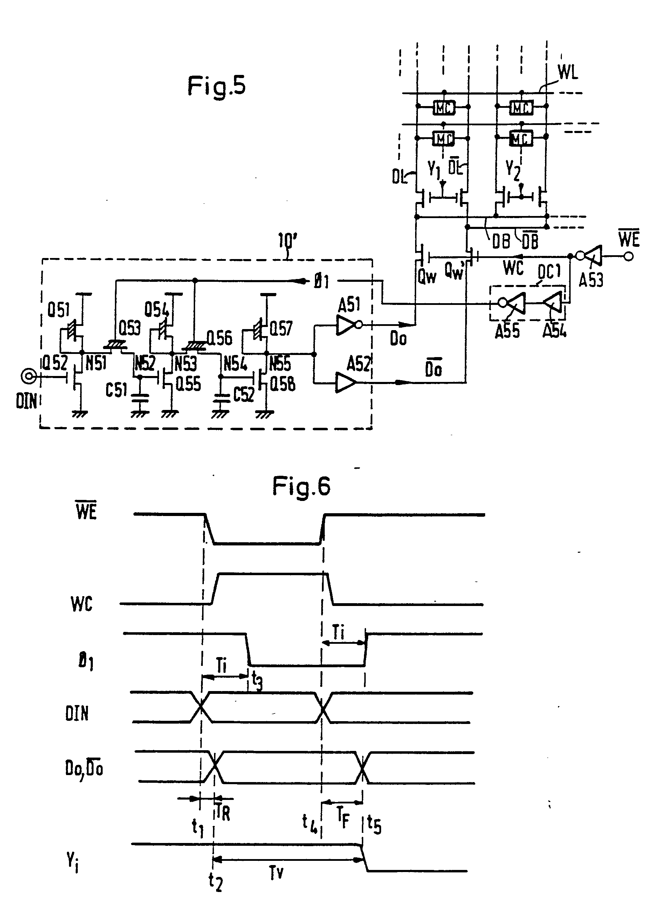

On the other hand, the case where the time difference $T_0$ is too short will be explained with reference to Fig. 4.

Fig. 4 shows the case where a write state continues for a long time by a low level of $\overline{WE}$, and an address input signal and DIN have been switched simultaneously at a time point $t_c$. If the time difference $T_0$ is too short, then since the data circuit output is switched during the period when a write operation to a selected memory cell is still effective, that is, before the selection of the column or row is changed at a time point $t_E$, in the worst case there occurs an inconvenience that inverse input data is rewritten in the same memory cell, resulting in an erroneous write operation.

According to the present invention, there is provided a signal transmitting circuit in which the requirement in the prior art that the time difference $T_0$ must be regulated to an appropriate value, can be mitigated and hence a margin of DIN for write operation can be broadened.

According to the present invention, under a write condition introduced by a $\overline{WE}$ signal of a short pulse as shown in Fig. 3 the transmission time $T_0$ for the input signal DIN is made short, whereas under a long write condition as illustrated in Fig. 4 the transmission time $T_0$ is elongated, and so, there is an advantage that a margin in time of the input signal DIN for write operation can be broadened.

Now one preferred embodiment of the present invention will be described with reference to Fig. 5. In this figure, component parts equivalent to those shown in Fig. 1 are designated by like reference numerals.

In Fig. 5, a dash-line block 10' represents a data circuit according to the present invention. Transistors $Q_{51}$ to $Q_{58}$ are all N-channel MISFET's. This data circuit 10' comprises a first stage inverter connected to an input terminal DIN and consisting of a depletion type MISFET $Q_{51}$ and a enhancement type MISFET $Q_{52}$, a second stage inverter consisting of a depletion type MISFET $Q_{54}$ and an enhancement type MISFET $Q_{55}$, a third stage inverter consisting of a depletion type MISFET $Q_{57}$ and an enhancement type MISFET $Q_{58}$, a depletion type MISFET $Q_{53}$ connected between an output point $N_{51}$ of the first stage inverter and an input point $N_{52}$ of the second stage inverter and having a signal $\phi_1$ applied to its gate, a depletion type MISFET $Q_{56}$ connected between an output point $N_{53}$ of the second stage inverter and an input point $N_{54}$ of the third stage inverter and having the signal $\phi_1$ applied to its gate, a capacitor $C_{51}$ connected between the input point $N_{52}$ of the second stage inverter and the ground, a capacitor $C_{52}$ connected between the input point $N_{54}$ of the third stage inverter and the ground, and an inverter $A_{51}$ and a buffer $A_{52}$ both connected to an output point $N_{55}$ of the third stage inverter. In this circuit arrangement, the MISFET's $Q_{53}$ and $Q_{56}$ are used as variable resistors which take a high resistance when the signal $\phi_1$ is at a "0" level and take a low resistance when the signal $\phi_1$ is at a "1" level. An inverter $A_{53}$ connected to a write terminal $\overline{WE}$ generates an internal write signal WC for controlling write gates $Q_w$ and $Q_w'$. A delay circuit DC1 includes two stages $A_{54}$ and $A_{55}$, and it generates the signal $\phi_1$ by delaying the internal write signal WC for a period of $T_1$.

The combination of the MISFET $Q_{53}$ and the capacitor $C_{51}$ and the combination of the MISFET $Q_{56}$ and the capacitor $C_{52}$, respectively, form time constant circuits. This data circuit 10' has a large input-output delay characteristic when the signal $\phi_1$ is at a "0" level, while it has a small input-output delay characteristic when the signal $\phi_1$ is at a "1" level.

Now, the operation of the circuit shown in Fig. 5 will be explained with reference to Fig. 6. At a time point $t_1$ the write signal $\overline{WE}$ changes to a low level and at the same time an input data DIN becomes effective. At this moment, since the signal $\phi_1$ is at a "1" level, the resistances of the MISFET's $Q_{53}$ and $Q_{56}$ are small, that is, as the conductances of these MISFET's $Q_{53}$ and $Q_{56}$ are

large, the time constants between the nodes $N_{51}$ and $N_{52}$ and between the nodes $N_{53}$ and $N_{54}$ are small, and hence at a time point $t_2$ when a period $T_R$ has elapsed from the time point $t_1$ true and complementary outputs $D_0$ and $\overline{D_0}$ of the data circuit 10' becomes effective. At a moment $t_3$ when the delay time $T_1$ of the delay circuit DC1 has elapsed from the time point $t_1$, the signal $\phi_1$ changes to a "0" level. Consequently, the resistances of the MISFET's $Q_{53}$ and $Q_{56}$ become large, that is, their conductances become small, and so, the transmission delay time of the data circuit 10' is increased. Hence, though the data DIN changes at a time point $t_4$, the outputs $D_0$ and $\overline{D_0}$ of the data circuit 10' are retained for a period of $T_F$ from this point $t_4$, so that these outputs $D_0$ and $\overline{D_0}$ are still effective until a time point $t_5$ when the address selection is still effective. Accordingly, a write effective period $T_v$ can be substantially enlarged.

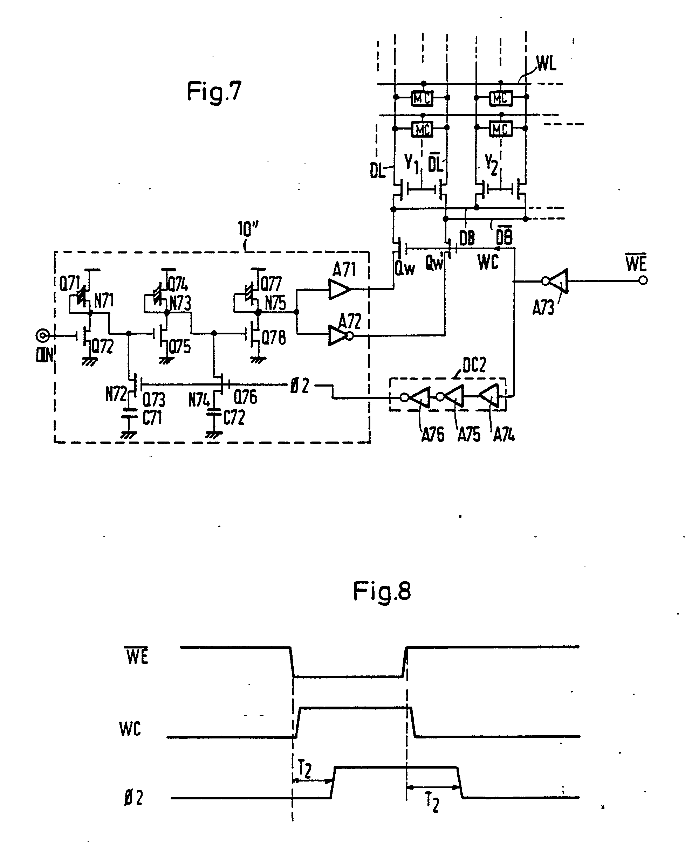

Another preferred embodiment of the present invention will be explained with reference to Fig. 7.

In this preferred embodiment, in order to control a transmission characteristic of a data circuit 10'', a series circuit of an enhancement type MISFET $Q_{73}$ and a capacitor $C_{71}$ and a series circuit of an enhancement type MISFET $Q_{76}$ and a capacitor $C_{72}$ are respectively connected between an output point $N_{71}$ of a first stage inverter consisting of a depletion type MISFET $Q_{71}$ and an enhancement type MISFET $Q_{72}$ and the ground, and between an output point $N_{73}$ of a second stage inverter consisting of a depletion type MISFET $Q_{74}$ and an enhancement type MISFET $Q_{75}$ and the ground, and a signal $\phi_2$ is applied to the gates of the MISFET's $Q_{73}$ and $Q_{76}$, so that a high speed transmission characteristic may be obtained when the signal $\phi_2$ is at a "0" level, whereas the capacitors $C_{71}$ and $C_{72}$ may be respectively added to the nodes $N_{71}$ and $N_{73}$ to enlarge the corresponding time constant and thereby a low speed transmission characteristic may be obtained when the signal $\phi_2$ is at a "1" level. The signal $\phi_2$ is a signal delayed by a period $T_2$ with respect to the write signal WE as shown in Fig. 8, which signal $\phi_2$ is produced by passing the signal WC through delay circuit $DC_2$ which is composed of stages $A_{74}$ to $A_{76}$. Accordingly, in the data circuit 10'', during the delay time $T_2$ from the moment when the data input DIN has become effective, since the signal $\phi_2$ is at a low level, the MISFET's $Q_{73}$ and $Q_{76}$ are not conducting. Hence, the loads at the nodes $N_{71}$ and $N_{73}$ are light, and the input signal transmits quickly to a node $N_{75}$. If a write condition sustains for a long time, then the signal $\phi_2$ becomes a high level, so that the MISFET's $Q_{73}$ and $Q_{76}$ become conducting, and as the load capacitors at the nodes $N_{72}$ and $N_{74}$ are added to the nodes $N_{71}$ and $N_{73}$, respectively, the input signal transmission speed is slowed down and the DIN signal transmits to the node $N_{75}$ slowly. After all, the same result as the preferred embodiment shown in Fig. 5 can be obtained. In this way, according to the illustrated embodiments of the present invention, a margin in time of a signal DIN for write operation can be broadened.

While the present invention has been described above in connection to its preferred embodiments, the circuit arrangement should not be limited to the illustrated embodiments but could be modified according to the situation.

In addition, while description has been made above in connection to circuits employing N-channel MISFET's, the present invention does not exclude application of P-channel MISFET's. Furthermore, if the method shown in Fig. 7 is employed, then it is possible to apply the present invention to a logic circuit employing bipolar transistors or the like.

## Claims

1. A signal transmitting circuit (10) comprising a first series connection of a first transistor ($Q_{52}$, $Q_{72}$) and a first load element ($Q_{51}$, $Q_{71}$) at a first junction ($N_{51}$, $N_{71}$) a second series connection of the second transistor ($Q_{55}$, $Q_{75}$) and a second load element ($Q_{54}$, $Q_{74}$) at a second junction ($N_{53}$, $N_{73}$), means for supplying a control electrode of said first transistor with an input signal, means for receiving a control signal ($\overline{WE}$) having first and second logic levels, said input signal being provided during a first period when said control signal assumes said first logic level (Low), a variable time constant circuit ($Q_{53}$, $C_{51}$; $Q_{73}$, $C_{71}$) coupled between said first junction ($N_{51}$, $N_{71}$) and a control electrode of said second transistor, control means ($A_{53}$ to $A_{55}$, $A_{73}$ to $A_{76}$) responsive to said control signal for setting a delay time at the control electrode of said second transistor caused by said variable time constant circuit at one of a first delay time ($T_R$) and a second delay time ($T_F$) longer than said first delay time, and output means ($Q_{56}$ to $Q_{58}$, $Q_{76}$ to $Q_{78}$) for deriving an output signal from said second junction ($N_{53}$, $N_{73}$) characterized in that said control means makes the delay time at the control electrode of said second transistor said first delay time ($T_R$) when said control signal changes from said second (H) level to said first (L) level and said second delay time ($T_F$) when said control signal changes from said first (L) level to said second level (H) irrespective of the value of said input signal, and that the output signal is derived during a second period longer than said first period.

2. The circuit according to claim 1, characterized in that said variable time constant circuit includes a variable resistor ($Q_{53}$) coupled between said first junction ($N_{51}$) and the control electrode of said second transistor ($Q_{55}$), said variable resistor taking a first resistance value when said control signal is in said second logic level (H) and taking a second resistance value larger than said first resistance value when said control signal is in said first logic level (L) and a capacitor ($C_{51}$) coupled between the control electrode of said

second transistor ($Q_{55}$) and a fixed potential point (GND).

3. The circuit according to claim 1, characterized in that said variable time constant circuit includes a circuit connection between the said first junction ($N_{71}$) and the control electrode of said second transistor ($Q_{75}$) and a third series connection of a third transistor ($Q_{73}$) and a capacitor ($C_{71}$) coupled between said circuit connection and a fixed point (GND), said third transistor ($Q_{73}$) being non-conducting when said control signal ($\overline{WE}$), changes from said second level to said first logic level and conducting when said control signal changes from said first level to said second logic level.

4. The circuit according to claim 1, characterized in that said control signal is a write control signal and said input signal is a data signal to be written into a selected memory cell in a memory.

**Patentansprüche**

1. Signalübertragungsschaltung (10) mit einer Reihenschaltung aus einem ersten Transistor ($Q_{52}$, $Q_{72}$) und einem ersten Lastelement ($Q_{51}$, $Q_{71}$) an einem ersten Knotenpunkt ($N_{51}$, $N_{71}$), mit einer zweiten Reihenschaltung aus einem zweiten Transistor ($Q_{55}$, $Q_{75}$) und einem zweiten Lastelement ($Q_{54}$, $Q_{74}$) an einem zweiten Knotenpunkt ($N_{53}$, $N_{73}$), einer Vorrichtung zum Versorgen einer Steuerelektrode des ersten Transistors mit einem Eingangssignal, einer Vorrichtung zum Empfangen eines Steuersignals ($\overline{WE}$) mit einem ersten und zweiten logischen Pegel, wobei das Eingangssignal zugeführt wird, während eines ersten Zeitraumes, wenn das Steuersignal den ersten logischen Pegel (Low) einnimmt, mit einer Schaltung ($Q_{53}$, $C_{51}$; $Q_{73}$, $C_{71}$) mit variabler Zeitkonstante, welche zwischen dem ersten Knotenpunkt ($N_{51}$, $N_{71}$) und eine Steuerelektrode des zweiten Transistors geschaltet ist, mit einer Steuervorrichtung ($A_{53}$ bis $A_{55}$, $A_{73}$ bis $A_{76}$), die in Abhängigkeit vom Steuersignal eine Verzögerungszeit an der Steuerelektrode des zweiten Transistors durch die Schaltung mit variabler Zeitkonstante auf eine erste Verzögerungszeit ($T_R$) setzt und auf eine zweite Verzögerungszeit ($T_F$), die länger als die erste Verzögerungszeit ist, und mit einer Ausgangsvorrichtung ($Q_{56}$ bis $Q_{58}$, $Q_{76}$ bis $Q_{78}$) zum Abziehen eines Ausgangssignals vom zweiten Knotenpunkt ($N_{53}$, $N_{73}$), dadurch gekennzeichnet, daß die Steuervorrichtung die Verzögerungszeit an der Steuerelektrode des zweiten Transistors auf die erste Verzögerungszeit ($T_R$) setzt, wenn sich das Steuersignal vom zweiten Pegel (H) auf den ersten Pegel (L) ändert, und auf die zweite Verzögerungszeit ($T_F$), wenn sich das Steuersignal vom ersten Pegel (L) auf den zweiten Pegel (H) ändert, unabhängig vom Wert des Eingangssignals, und daß das Ausgangssignal während einer zweiten Zeitspanne abgezogen wird, die länger also die erste Zeitspanne ist.

2. Schaltung nach Anspruch 1, dadurch gekennzeichnet, daß die Schaltung mit variabler Zeitkon-

stante einen variablen Widerstand ($Q_{53}$) aufweist, der zwischen dem ersten Knotenpunkt ($N_{51}$) und die Steuerelektrode des zweiten Transistors ($Q_{55}$) geschaltet ist, wobei der variable Widerstand einen ersten Widerstandswert annimmt, wenn das Steuersignal auf dem zweiten logischen Pegel (H) liegt, und einen zweiten Widerstandswert annimmt, der größer ist als der erste Widerstandswert, wenn das Steuersignal auf dem ersten logischen Pegel (L) liegt, und einen Kondensator ($C_{51}$), der zwischen die Steuerelektrode des zweiten Transistors ($Q_{55}$) und einen Festpotentialpunkt (GND) geschaltet ist.

3. Schaltung nach Anspruch 1, dadurch gekennzeichnet, daß die Schaltung mit variabler Zeitkonstante eine erste Schaltkreisverbindung zwischen dem ersten Knotenpunkt ($N_{71}$) und der Steuerelektrode des zweiten Transistors ($Q_{75}$) aufweist und eine dritte Reihenschaltung eines dritten Transistors ($Q_{73}$) und eines Kondensators ($C_{71}$), die zwischen die Schaltkreisverbindung und einen Festpotentialpunkt (GND) geschaltet ist, wobei der dritte Transistor ($Q_{73}$) nichtleitend ist, wenn das Steuersignal ($\overline{WE}$) vom zweiten Pegel auf den ersten Pegel wechselt, und leitfähig, wenn das Steuersignal vom ersten Pegel zum zweiten logischen Pegel wechselt.

4. Schaltung nach Anspruch 1, dadurch gekennzeichnet, daß das Steuersignal ein Schreibsteuersignal ist und das Eingangssignal ein Datensignal, welches in eine ausgewählte Speicherzelle eines Speichers geschrieben werden soll.

**Revendications**

1. Circuit de transmission de signal (10) comprenant une première connexion en série d'un premier transistor ($Q_{52}$, $Q_{72}$) et d'un premier élément de charge ($Q_{51}$, $Q_{71}$) à une première jonction ($N_{51}$, $N_{71}$), une seconde connexion en série d'un second transistor ($Q_{55}$, $Q_{75}$) et d'un second élément de charge ($Q_{54}$, $Q_{74}$) à une seconde jonction ($N_{53}$, $N_{73}$), un moyen pour fournir à une électrode de commande du premier transistor un signal d'entrée, un moyen pour recevoir un signal de commande ($\overline{WE}$) ayant des premier et second niveaux logiques, le signal d'entrée étant fourni pendant une première période lorsque le signal de commande prend le premier niveau logique (Bas), un circuit à constante de temps variable ($Q_{53}$, $C_{51}$; $Q_{73}$, $C_{71}$) branché entre la première jonction ($N_{51}$, $N_{71}$) et une électrode de commande du second transistor, un moyen de commande ($A_{53}$ à $A_{55}$, $A_{73}$ à $A_{76}$) sensible au signal de commande pour régler un temps de retard à l'électrode de commande du second transistor dû au circuit à constante de temps variable à l'un d'un premier temps de retard ($T_R$) et d'un second temps de retard ($T_F$) plus long que le premier temps de retard, et un moyen de sortie ($Q_{56}$ à $Q_{58}$, $Q_{76}$ à $Q_{78}$) pour donner un signal de sortie en provenance de la seconde jonction ($N_{53}$, $N_{73}$), caractérisé en ce que le moyen de command fait en sorte que le temps de retard à l'électrode de commande du second transistor soit le premier temps de retard ($T_R$) lorsque le signal de commande passe du second niveau (H) au premier niveau (B) et soit le second temps de retard ($T_F$) lorsque le signal de commande passe du premier niveau (B) au second niveau (H) quelle que soit la valeur du signal d'entrée, et en ce que le signal de sortie est obtenu pendant une seconde période supérieure à la première période.

2. Circuit selon la revendication 1, caractérisé en ce que le circuit à constante de temps variable comporte une résistance variable ($Q_{53}$) montée entre la première jonction ($N_{51}$) et l'électrode de commande du second transistor ($Q_{55}$), cette résistance variable prenant une première valeur de résistance lorsque le signal de commande se trouve dans le second niveau logique (H) et prend une seconde valeur de résistance supérieure à la première valeur de résistance lorsque le signal de commande se trouve dans le premier niveau logique (B) et un condensateur ($C_{51}$) couplé entre l'électrode de commande du second transistor ($Q_{55}$) et un point à potentiel fixe (GND).

3. Circuit selon la revendication 1, caractérisé en ce que le circuit à constante de temps variable comporte une liaison de circuit entre la première jonction ($N_{71}$) et l'électrode de commande du second transistor ($Q_{75}$) et une troisième connexion en série d'un troisième transistor ($Q_{73}$) et d'un condensateur ($C_{71}$) couplée entre la connexion de sortie et un point fixe (GND), le troisième transistor ($Q_{73}$) étant non conducteur lorsque le signal de commande ($\overline{WE}$) passe du second niveau au premier niveau logique et conducteur lorsque le signal de commande passe du premier niveau au second niveau logique.

4. Circuit selon la revendication 1, caractérisé en ce que le signal de commande est un signal de commande d'écriture et le signal d'entrée est un signal de données devant être écrit dans une cellule de mémoire sélectionnée dans une mémoire.

Fig.1 (prior Art)

Fig.2 (prior Art)

1

# Fig.3

$\overline{WE}$ (write)

DIN /// Valid ///

Address Input

Do, $\overline{Do}$ /// Valid ///

$T_0$ $T_0$

Column or Row Selection $t_1$ $t_2$

$T_V$

$t_S$ $t_E$

# Fig.4

$\overline{WE}$ (write)

DIN /////////////

Address Input

Do, $\overline{Do}$ ///// Valid /////

$T_0$

$t_C$

$T_V$

$t_E$

2

## Fig.5

## Fig.6

## Fig.7

## Fig.8

4